# EUROPEAN PATENT SPECIFICATION

(11) **EP 1 918 631 B1**
(45) Date of publication and mention of the grant of the patent: **08.05.2013**
(21) Application number: 07119579.6
(22) Date of filing: 30.10.2007
(51) Int. Cl.: F17C 13/12

(54) **Leak containment system for reactive gases**
Leckeindämmungssystem für reaktive Gase
Système de confinement de fuites pour gaz réactifs

(30) Priority: 31.10.2006 US 590029
(43) Date of publication of application: 07.05.2008
(73) Proprietor: Air Products and Chemicals, Inc., Allentown, PA 18195-1501 (US)
(72) Inventor: Martrich, Robert Lee, Emmaus, PA 18049 (US); Whitesell, Gordon Leon, Pottsville, PA 17901 (US); Ngai, Eugene Yin, Whitehouse Station, NJ 08889 (US); Deitos, James Francis, Emmaus, PA 18049 (US)
(74) Representative: Muir, Benjamin M. J.

(56) References cited:
- DE-A1- 10 308 676
- DE-C1- 19 543 485
- DE-U1- 20 117 492
- US-A- 1 413 502
- US-A- 4 478 345
- US-A- 4 834 137
- US-A- 5 086 804
- US-A- 5 158 204
- US-A- 6 003 540

## Description

### BACKGROUND OF THE INVENTION

Reactive gases are used in many process steps in the fabrication of microelectronic components, optical components, analytical instruments, and other specialized equipment. Most of these reactive gases are highly hazardous to operating personnel, and the manufacture, storage, transportation, and end use of these gases must be carried out under strict safety procedures. These gases are transported and stored at ambient temperatures in pressurized cylinders either as compressed gases or as pressurized saturated liquids. The pressurized cylinders may be individual standalone cylinders or may be multiple-tube bundles used in tube trailers or ISO containers.

Each storage cylinder is fabricated with at least one discharge port, and the port typically is threaded for the installation of fluid flow fittings such as shutoff valves, bull plugs, and other fittings that are connected in turn to valve and piping systems that supply gas to an end user. Leaks may occur in a fluid flow fitting at threaded connections, compression fittings, O-ring seals, valve stem packings, and valve seats. In many cases, these leaks are small (e.g., less than about 50 sccm), but even small leaks can be hazardous and may develop into larger and possibly catastrophic leaks. If leaks occur at an operating plant in which the cylinders are filled, appropriate safety equipment and procedures will be available to contain the leak and repair the leaking components. If leaks occur during cylinder transportation or while a cylinder is stored at a user's site, however, appropriate equipment and procedures to contain the leak and repair the leaking components may not be available.

US-A-5 158 204 discloses a secure cap for gas bottles

There is a need in the art for methods of containing such leaks during cylinder transportation and storage in the time period between initial leak detection and the return of the leaking cylinder to a properly-equipped repair facility. This need is addressed by the embodiments of the invention described below and defined by the claims that follow.

### BRIEF SUMMARY OF THE INVENTION

One embodiment of the invention provides a fluid storage and leak containment system comprising (a) a fluid storage vessel system comprising at least one vessel having an interior, an exterior, and an outlet opening between the interior and the exterior; (b) a fluid flow fitting sealably connected to the outlet opening and adjacent the exterior of the at least one vessel, wherein the fluid flow fitting is adapted for withdrawing reactive gas from the interior of the vessel; and (c) a containment enclosure having an interior, an exterior, an open end, and an extraction port adapted for the withdrawal of gas from the interior of the containment enclosure, wherein the open end is adapted to fit over and around the fluid flow fitting such that the containment enclosure surrounds the fluid flow fitting and is adapted to collect any reactive gas leaking from the fluid flow fitting.

Another embodiment of the invention is a leak containment cap comprising an enclosure having an interior, an exterior, an open end, and an extraction port adapted for the withdrawal of gas from the interior of the enclosure, wherein the open end is adapted to fit over and around a fluid flow fitting that is connected to an outlet of a fluid storage vessel of a fluid storage vessel system, and wherein the enclosure is adapted to surround the fluid flow fitting and contact the fluid storage vessel system; and a removable attachment member connected to the containment enclosure, wherein the removable attachment member is adapted to removably attach the containment enclosure to the fluid storage vessel system and to press the open end of the enclosure against the fluid storage vessel system around the fluid flow fitting.

A related embodiment is a method for containing a leak of a reactive gas from a fluid storage vessel system comprising
(a) providing a fluid storage vessel and leak containment system including
   (1) a fluid storage vessel system including at least one fluid storage vessel having an interior, an exterior, and an outlet opening between the interior and the exterior;
   (2) a fluid flow fitting sealably connected to the outlet opening and adjacent the exterior of the at least one fluid storage vessel, wherein the fluid flow fitting is adapted for withdrawing reactive gas from the interior of the vessel; and
   (3) a leak containment cap comprising (i) an enclosure having an interior, an exterior, an open end, and an extraction port adapted for the withdrawal of gas from the interior of the leak containment cap, wherein the open end is adapted to fit over and around a fluid flow fitting connected to an outlet of the at least one fluid storage vessel such that the enclosure can surround the fluid flow fitting and contact the fluid storage vessel system, and (ii) a removable attachment member connected to the enclosure, wherein the removable attachment member is adapted to removably attach the enclosure to the fluid storage vessel system and to press the open end of the enclosure against the fluid storage vessel system around the fluid flow fitting;
(b) detecting a leak of the reactive gas from the fluid flow fitting;
(c) placing the enclosure over and around the fluid flow fitting and attaching the removable attachment member to the fluid storage vessel system so that the enclosure completely surrounds the fluid flow fitting; and
(d) collecting in the enclosure reactive gas leaking from the fluid flow fitting, withdrawing through the extraction port the reactive gas collected in the enclosure, and reacting the reactive gas with reactive material, thereby capturing and immobilizing the reactive gas leaking from the fluid flow fitting.

Another related embodiment of the invention includes a fluid storage and leak containment system comprising
(a) a fluid storage vessel system comprising a plurality of fluid storage vessels, each fluid storage vessel having an interior, an exterior, an outlet opening between the interior and the exterior, and a fluid flow fitting sealably connected to the outlet opening and adjacent the exterior of the fluid storage vessel, wherein the fluid flow fitting is adapted for withdrawing a reactive gas from the interior of the vessel;
(b) a leak containment cap comprising (i) an enclosure having an interior, an exterior, an open end, and an extraction port adapted for the withdrawal of gas from the interior of the enclosure, wherein the open end is adapted to fit over and around a fluid flow fitting connected to an outlet of the fluid storage vessel such that the enclosure can surround the fluid flow fitting and contact the fluid storage vessel system, and (ii) a removable attachment member connected to the enclosure, wherein the removable attachment member is adapted to removably attach the enclosure to the fluid storage vessel system and to press the open end of the enclosure against the fluid storage vessel system around the fluid flow fitting;
(c) a scrubbing vessel having an inlet in flow communication with the extraction port and an outlet, wherein the scrubbing vessel contains reactive material adapted to react with and capture the reactive gas withdrawn from the leak containment cap; and
(d) a venturi eductor having a pressurized gas inlet, an aspirated inlet, and an outlet, wherein the aspirated inlet is in flow communication with the scrubbing vessel.

A final embodiment of the invention provides a method for responding to a leak of a reactive gas from a pressurized storage vessel system comprising
(a) providing a fluid storage and leak containment system including
   (1) a fluid storage vessel system comprising at least one fluid storage vessel having an interior, an exterior, and an outlet opening between the interior and the exterior;
   (2) a fluid flow fitting sealably connected to the outlet opening and adjacent the exterior of the at least one fluid storage vessel, wherein the fluid flow fitting is adapted for withdrawing reactive gas from the interior of the vessel; and
   (3) a leak containment cap comprising (i) an enclosure having an interior, an exterior, an open end, and an extraction port adapted for the withdrawal of gas from the interior of the enclosure, wherein the open end is adapted to fit over and around a fluid flow fitting connected to an outlet of the at least one fluid storage vessel such that the enclosure can surround the fluid flow fitting and contact the exterior of the fluid storage vessel system, and (ii) a removable attachment member connected to the enclosure, wherein the removable attachment member is adapted to removably attach the enclosure to the fluid storage vessel system and to press the open end of the enclosure against the fluid storage vessel system around the fluid flow fitting;
(b) detecting a leak of the reactive gas from the fluid flow fitting;
(c) placing the enclosure over and around the fluid flow fitting and attaching the removable attachment member so that the enclosure surrounds the fluid flow fitting, and collecting in the enclosure the reactive gas leaking from the fluid flow fitting;
(d) withdrawing through the extraction port a mixture of the reactive gas collected in the enclosure and ambient air drawn into the enclosure, and reacting the reactive gas with reactive material, thereby capturing and immobilizing the reactive gas leaking from the fluid flow fitting;
(e) while continuing to capture and immobilize the reactive gas from the fluid storage vessel, transporting the fluid storage vessel system to a repair facility; and
(f) removing the reactive gas from the fluid storage vessel and replacing or repairing the fluid flow fitting.

### BRIEF DESCRIPTION OF SEVERAL VIEWS OF THE DRAWINGS

Fig. 1 is a schematic view of a fluid flow fitting for the withdrawal of gas from a cylinder that is part of a multiple-cylinder fluid storage vessel system.
Fig. 2 is a schematic view of a containment enclosure shown in cross section placed over and around the fluid flow fitting according to an embodiment of the invention.
Fig. 3 is a view of section A-A of Fig. 2.
Fig. 4 is an alternative schematic view of the containment enclosure of Fig. 2 (shown in cross section) placed over and around the fluid flow fitting and attached to a part of the fluid storage vessel system according to an embodiment of the invention.
Fig. 5 is an external view of the containment enclosure of Fig. 5.
Fig. 6 is a schematic process flow diagram for an embodiment of the invention.
Fig. 7 is a schematic process flow diagram for an alternative embodiment of the invention.

### DETAILED DESCRIPTION OF THE INVENTION

The embodiments of the present invention provide methods and systems for collecting and capturing reactive gas that escapes from a leaking fluid storage vessel system. The collection system may be operated to capture the leaking reactive gas until the fluid storage vessel system can be repaired by withdrawing the reactive gas from the storage vessel system and replacing the leaking components. In one embodiment, the collection system may be operated during transportation of the fluid storage vessel system to a repair facility.

The collection system may be carried in the inventory of an emergency response vehicle for immediate delivery to a leak site to capture gas leaking from a fluid storage vessel system. The collection system also may be carried on a truck or a cab/trailer of a mobile fluid storage vessel system so that the collection system is available for immediate use if a leak occurs. The fluid storage vessel system may be, for example, a plurality of horizontal cylinders assembled in a tube trailer, a plurality of horizontal cylinders assembled as an ISO container transportable by flatbed trailer, or individual cylinders carried on a truck or cab/trailer.

Reactive gases are stored in pressurized cylinders at ambient temperatures either as compressed gases or as pressurized saturated liquids. The pressurized cylinders may be individual standalone cylinders or may be bundles of horizontal cylinders assembled in tube trailers or in ISO containers as described above. Pressurized fluid storage cylinders are fabricated with at least one discharge port, and the port typically is threaded internally for the installation of fluid flow fittings that comprise bull plugs, shutoff valves, connections to piping leading to safety relief devices, and connections to end user gas delivery piping. Leaks may occur in a fluid flow fitting at threaded, O-ring, flared, or ferrule-type connections between the fluid flow fitting and valves or external piping systems, at a valve stem packing, or across a valve seat.

The term "fluid storage vessel system" is defined as a system comprising one or more fluid storage vessels, for example cylinders, designed for the storage of pressurized fluids including compressed gases and pressurized liquids. Fluid storage vessel systems include single standalone cylinders, multiple cylinders grouped and assembled for mounting on trucks or trailers, and multiple cylinders grouped and assembled in a framework as shippable ISO containers. A fluid storage vessel system thus includes any cylinder or group of cylinders containing compressed gas or pressurized liquid, wherein each cylinder includes an associated fluid flow fitting.

A fluid flow fitting is a device connected to an outlet of a fluid storage vessel through which gas flows during withdrawal from the vessel. The fluid flow fitting includes one or more parts including but not limited to bull plugs, tees, connectors, O-ring seals, pipe thread joints, compression fittings, piping segments, and shutoff valves.

The term "reactive gas" is defined as any gas that reacts with liquids, solids, or other gases to form reaction products accompanied by the generation of heat. The term "reactive material" is defined as any liquid and/or solid material that reacts with a reactive gas to form reaction products, thereby capturing and immobilizing the reactive gas. The reactive material may undergo a chemical reaction with the reactive gas and/or adsorb the reactive gas.

The term "removably attached" refers to an attachment as for example provided by an attachment member connected to a containment enclosure as described below wherein the attachment member is adapted to be attached to and detached from a fluid storage vessel system. The attachment member may be removably connected to the containment enclosure or may be permanently connected to the containment enclosure.

The term "in flow communication with" as applied to a first and second region means that gas can flow from the first region to the second region through connecting piping and/or an intermediate region.

A repair facility is defined as a facility equipped and manned for the safe handling, processing, and repairing of a fluid storage vessel system that is leaking a reactive gas.

The indefinite articles "a" and "an" as used herein mean one or more when applied to any feature in embodiments of the present invention described in the specification and claims. The use of "a" and "an" does not limit the meaning to a single feature unless such a limit is specifically stated. The definite article "the" preceding singular or plural nouns or noun phrases denotes a particular specified feature or particular specified features and may have a singular or plural connotation depending upon the context in which it is used. The adjective "any" means one, some, or all indiscriminately of whatever quantity. The term "and/or" placed between a first entity and a second entity means one of (1) the first entity, (2) the second entity, and (3) the first entity and the second entity.

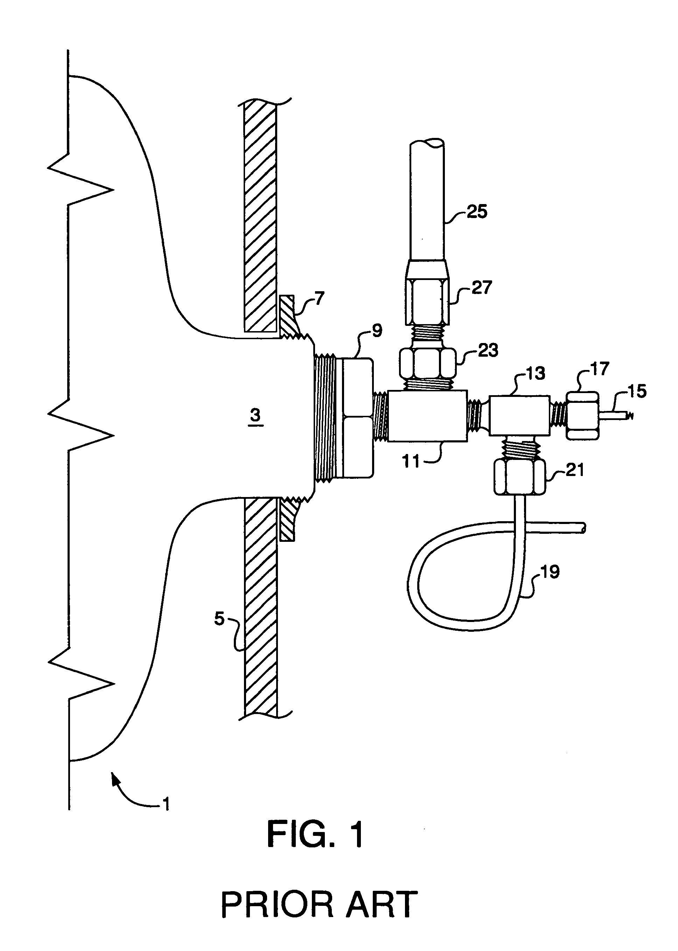

A typical fluid flow fitting for a multiple-vessel fluid storage system such as a tube trailer is illustrated in Fig. 1. Cylinder 1 has neck portion 3 supported in a circular opening in bulkhead 5 such that the bulkhead supports the vertical component of the cylinder weight and the cylinder is free to rotate slightly in the circular opening when the cylinder twists about its axis due to torsional forces. Neck 3 is threaded on the outer surface, and retaining collar 7 is threaded over the neck to locate and retain the cylinder in the axial direction. Cylinder 1 typically is supported at the other end in a similar support bulkhead, and the entire cylinder assembly is mounted on a truck or trailer by methods known in the art. Alternatively, cylinder 1 may be one of a plurality of cylinders grouped in a similar manner and mounted in an ISO-type container framework.

Neck 3 is internally threaded to receive externally-threaded bull plug 9, which has a center internally-threaded opening to receive an externally-threaded end of tee fitting 11. The seal between bull plug 9 and neck 3 is provided by an O-ring (not shown). Tee fitting 11 has an internally-threaded opening at the other end to receive an externally-threaded end of shutoff valve 13, and the valve is equipped with valve stem 15 mounted in valve packing section 17. Pigtail 19, which is connected to the outlet of valve 13 by compression fitting 21, supplies gas to a supply manifold (not shown) that is connected in turn to an end user's gas supply system. Tee fitting 11 also has an internally-threaded opening on the top section to receive one end of externally-threaded compression fitting body 23. Tube 25 is connected by compression fitting 27 at the other end of compression fitting body 23 and leads to a safety relief device (not shown). In some systems, a safety relief device is not used, and tee fitting 11, externally-threaded compression fitting body 23, tube 25, and compression fitting 27 are not required.

The fluid flow fitting of Fig. 1 may leak at any of the threaded and compression fittings shown or at the stem packing of shutoff valve 13. It has been observed in the development of the embodiments described below that leaks occur most often at the O-ring seal between cylinder neck 3 and bull plug 9. When such a leak occurs, replacement of the O-ring and possibly the bull plug is required, and the pressurized fluid in cylinder 1 must be withdrawn before this replacement can be effected. When leaks occur at the threaded or compression fitting connections on tee 11 as described above, cylinder 1 also must be emptied before replacement or repair of the leaking components can be effected. These repairs usually must be carried out in a central cylinder fill and maintenance facility. Most leaks, however, will occur at locations away from such a facility, and these leaks are problematic when the stored gas is hazardous and reactive. The embodiments of the invention described below provide methods to contain these leaks while the fluid vessel storage system is transported to a facility having the equipment to handle the leak or until an emergency response (ER) team can provide onsite disposal of the product fluid withdrawn from the leaking cylinder.

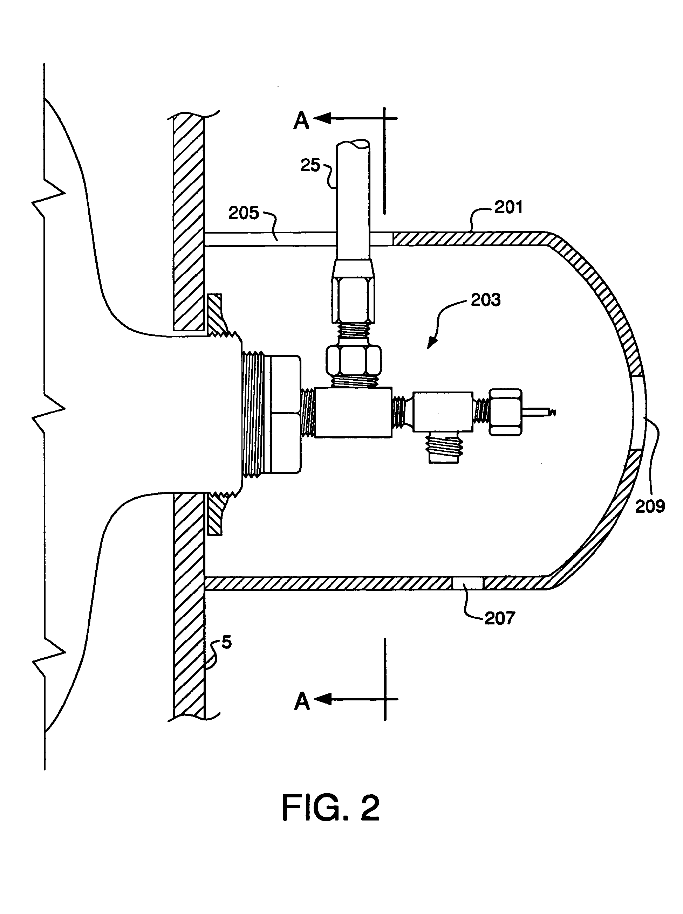

Embodiments of the invention include a containment enclosure that fits over and around the fluid flow fitting such that the containment enclosure surrounds the fluid flow fitting and is adapted to collect any reactive gas leaking from the fluid flow fitting. A typical containment enclosure is illustrated in Fig. 2 wherein containment enclosure 201 fits over and around fluid flow fitting 203 and is placed in contact with bulkhead 5. In this example, pigtail 9 and fitting 21 of Fig. 1 are removed before placement of containment enclosure 201. Slot 205 is provided in the wall of containment enclosure 201 so that the enclosure can be slipped over tube 25. As described later, this slot can be closed off (but typically not sealed) by appropriate methods using adhesive tape or a fabric with a hook-and-loop closure. At least one extraction port is provided for the withdrawal of collected leaking gas from the interior of the containment enclosure. In the embodiment of Fig. 2, two ports are provided - small port 207 for withdrawing gas from smaller leaks and larger port 209 for withdrawing gas from larger leaks. The port not in use can be plugged as needed (not shown). The containment enclosure may be fabricated from any metal, plastic, or composite material that is compatible with the leaking gas.

A system that does not require a safety relief device does not have tee fitting 11, externally-threaded compression fitting body 23, tube 25, and compression fitting 27. In this case, pigtail 19 is not removed and enclosure 201 can be placed over and around fluid flow fitting 203 such that slot 205 slides over pigtail 19. As described later, this slot can be closed off (but typically not sealed) by appropriate methods using adhesive tape or a fabric with a hook-and-loop closure.

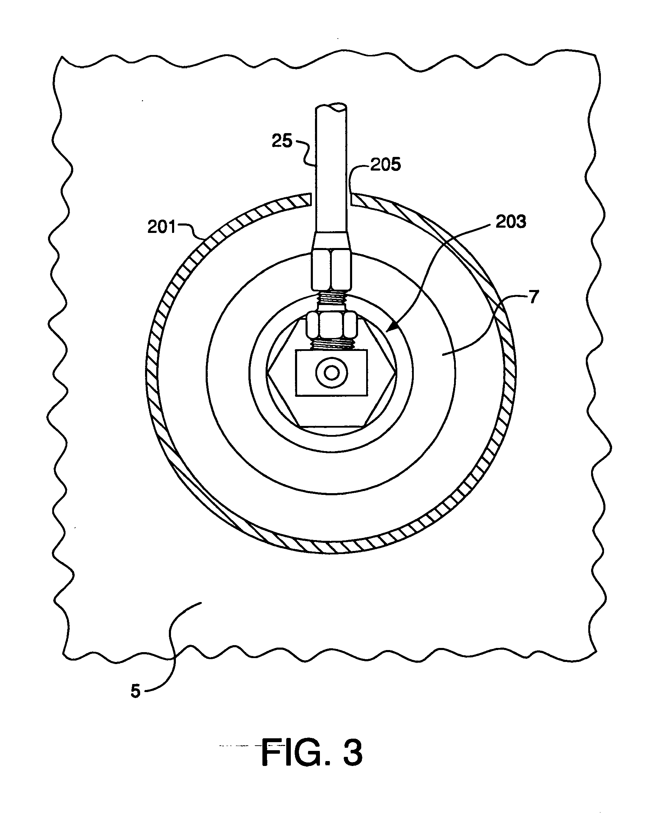

Fig. 3 is a view of section A-A of Fig. 2 showing containment enclosure 201 fitting over and around fluid flow fitting 203 in contact with bulkhead 5 outside of retaining collar 7. Slot 205 is shown in the wall of containment enclosure 201 allowing the enclosure to be slipped over tube 25.

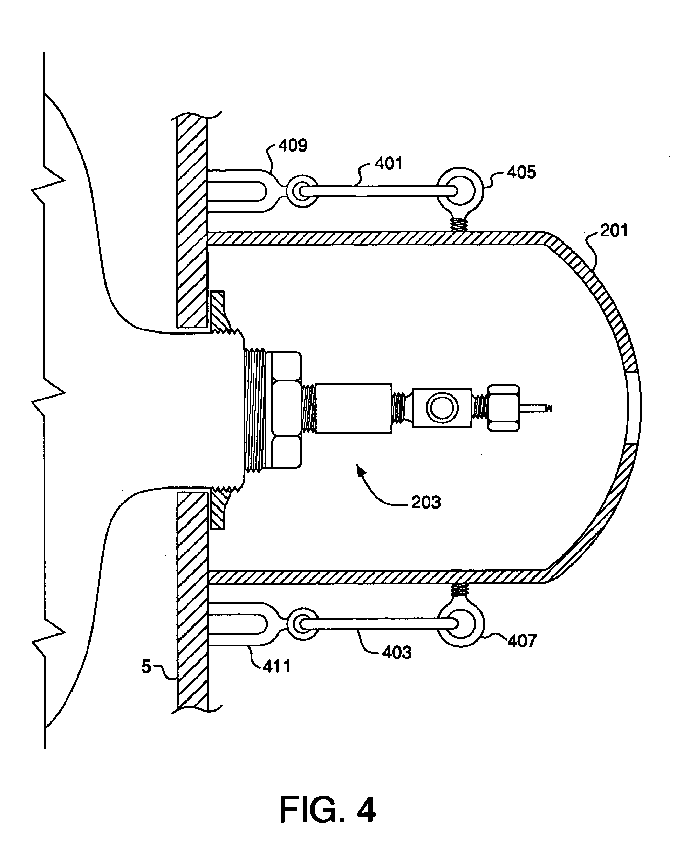

Containment enclosure 201 may be removably attached to the fluid storage vessel system around fluid flow fitting 203 when a leak occurs and detached for storage when the leak is repaired. The enclosure may be attached by any type of detachable connection system that is adapted to hold the enclosure in place around the fitting and against bulkhead 5. One type of detachable connection system is illustrated in the embodiment of Fig. 4, which is a bottom view orthogonal to the view of Fig. 2 showing containment enclosure 201 in section. In this embodiment, two elastic bodies or cords 401 and 403 are attached to containment enclosure 201 by eyebolts 405 and 407. The elastic cords are attached at the opposite ends to magnets 409 and 411 that are removably attached to bulkhead 5 (which typically is steel), thereby placing elastic cords in tension and forcing containment enclosure 201 against bulkhead 5. The elastic cords may be, for example, bungee cords or any other elastomeric material appropriate for the purpose of forcing containment enclosure 201 against bulkhead 5.

Alternatively, springs of appropriate length and diameter may be used instead of elastomeric cords. In another alternative, rope or webbing may be used in combination with tighten-and-release mechanisms. In an alternative to the use of magnets, eyebolts may be permanently attached to bulkhead 5 on either side of fluid flow fitting 203, and elastomeric cords or springs of appropriate length may be attached at one end to eyebolts 405 and 407 and provided with hooks at the other end for connection to the eyebolts on bulkhead 5. Other types of detachable connection systems can be envisioned to provide for the attachment and detachment of containment enclosure 201 to bulkhead 5.

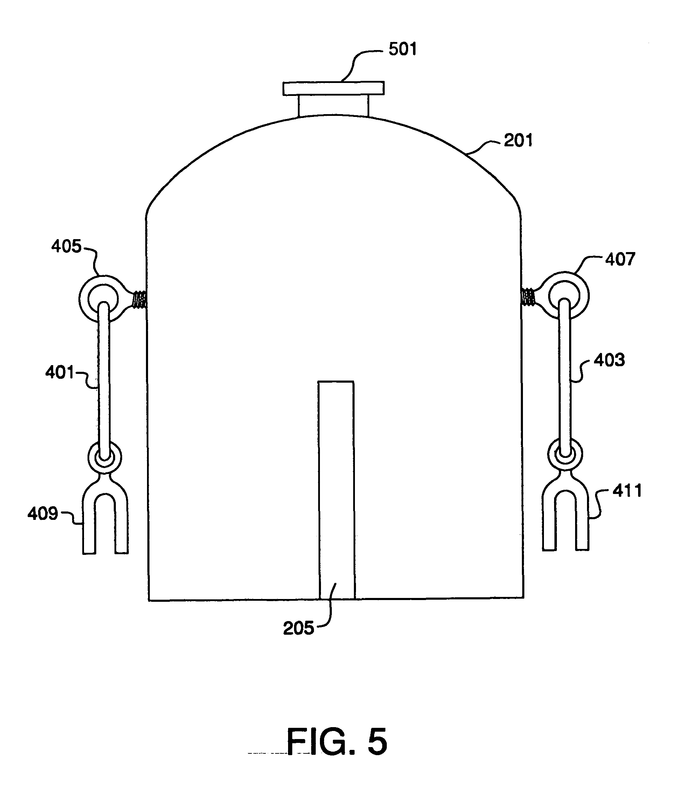

An external view of the embodiment of Fig. 4 is given in Fig. 5 showing containment enclosure 201, slot 205, elastic bodies or cords 401 and 403 (not in tension), eyebolts 405 and 407, and magnets 409 and 411. In this view, larger port 209 is closed off by cap 501. The combination of containment enclosure 201 with elastic bodies or cords 401 and 403, eyebolts 405 and 407, and magnets 409 and 411 may be defined as a type of leak containment cap.

A leak containment cap is defined generically as the combination of any containment enclosure adapted for leak containment as described above and any attachment member connectable to the containment enclosure. The attachment member is adapted to removably attach the containment enclosure to a fluid storage vessel system and to press the open end of the enclosure against the fluid storage vessel system around the fluid flow fitting as described above.

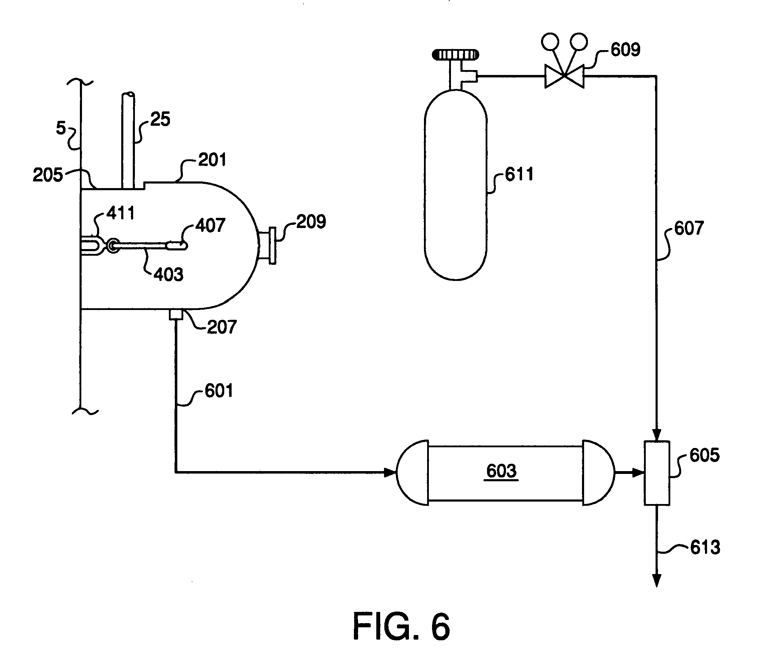

Leaking gas collected by containment enclosure 201 may be processed and captured by the embodiment illustrated in Fig. 6. When a leak in the fluid storage vessel system is detected, containment enclosure 201 is attached to bulkhead 5 by the elastic cords and magnets of Figs. 4 and 5 (cord 403, eyebolt 407, and magnet 411 are shown here). The opening of enclosure 201 is pressed against bulkhead 5 but preferably does not form a completely gas tight seal. Slot 205 is loosely closed around tube 25 using adhesive tape or hook-and-loop fabric (not shown). Small port 207 is connected to line 601 and larger port 209 is capped as shown. Line 601 is in flow communication with the inlet of scrubbing vessel 603 containing reactive material that reacts with and captures the gas leaking from the fluid storage vessel system. The reactive material may undergo a chemical reaction with the leaking gas and/or adsorb and/or absorb the gas, thereby capturing and immobilizing the gas.

The outlet of scrubbing vessel 603 is connected in flow communication with the aspirated inlet of venturi eductor 605, and line 607 is connected to the high pressure motive gas inlet of the eductor. Scrubbing vessel 603 is made of any material compatible with the leaking gas to be treated therein and compatible with the temperatures that occur during reaction with the collected gas. Line 607 is in flow communication with pressure regulator 609 mounted on high pressure gas supply cylinder 611, which provides gas for flow through venturi eductor 605 to generate a low pressure at the aspirated inlet. The high pressure gas may be, for example, nitrogen, other inert gas, or compressed air. Scrubbing vessel 603 is sized to process a relatively small gas leakage rate, for example, less that about 50 sccm, for up to about 100 hours. This vessel typically has a volume of approximately 2500 cm³.

The venturi eductor is operated to generate a slightly subatmospheric pressure at the aspirated inlet, thereby drawing gas from containment enclosure 201 through line 601 and scrubbing vessel 603. Because containment enclosure 201 is not completely sealed, an amount of atmospheric air enters the enclosure, thereby acting as a purge gas that mixes with the leaking reactive gas. This gas mixture is treated in scrubbing vessel 603, wherein the reactive gas is captured, and clean gas is vented to the atmosphere via line 613.

The reactive material used in scrubbing vessel 603 will depend on the reactive nature of the leaking gas and should be selected to properly react with and capture the leaking gas. The reactive material may be a caustic neutralizer such as sodium hydroxide or potassium hydroxide for capturing acid gases such as anhydrous ammonia. Other caustic reactive materials may be used as appropriate. For gases such as boron trichloride, boron trifluoride, carbonyl sulfide, hydrogen bromide, hydrogen chloride, hydrogen iodide, silicon tetrachloride, silicon tetrafluoride, trichlorosilane, and tungsten hexafluoride, an acid neutralizer such as citric acid or ascorbic acid may be used for the reactive material. Alternatively, an oxidizer such as potassium permanganate may be used. Other acidic or oxidizing materials may be used as appropriate. For fluorine or fluorine-containing gases, alumina is an appropriate reactive material. Scrubbing vessel 603 may be fabricated from a plastic material such as, for example, polyvinyl chloride (PVC). Alternatively, the scrubbing vessel may be fabricated from any appropriate metal such as carbon steel, stainless steel, or other corrosion-resistant alloys.

The containment system of Fig. 6 may be carried on a cylinder delivery truck or a tube trailer for immediate use when a small leak, for example less than 50 sccm, occurs. The containment system of Fig. 6 also may be carried on an emergency response (ER) vehicle for transportation to a leak site.

As an alternative to the embodiment of Fig. 6, venturi eductor 605 may be installed at the inlet to scrubbing vessel 603 such that the discharge of the eductor via line 613 passes through the scrubbing vessel. In this alternative (not shown), the scrubbing vessel processes a mixture containing the reactive gas, air entering containment enclosure 201, and motive gas from venturi eductor 603. In another alternative, a vacuum pump may be used instead of the venturi eductor at either the inlet or outlet of scrubbing vessel 603.

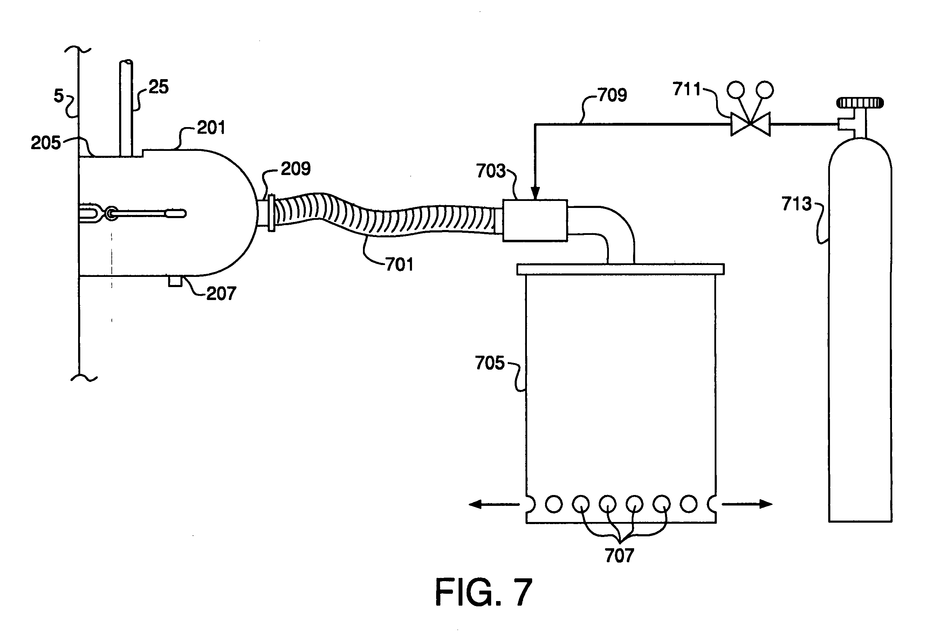

For larger leaks (for example, greater than 50 sccm), gas collected by containment enclosure 201 may be processed and captured by the embodiment illustrated in Fig. 7. When a leak in the fluid storage vessel system is detected, containment enclosure 201 is attached to bulkhead 5 as described above. The opening of enclosure 201 is pressed against bulkhead 5 but preferably does not form a completely gas tight seal. Slot 205 is loosely closed around tube 25 using adhesive tape or hook-and-loop fabric (not shown). Large port 209 is connected to flexible hose 701 and smaller port 207 is capped as shown. Hose 701 is in flow communication with the aspirated inlet of venturi eductor 703, which discharges into scrubbing drum 705 that contains a bed of reactive material that reacts with and captures the gas leaking from the fluid storage vessel system. The reactive material may undergo a chemical reaction with the leaking gas and/or adsorb the gas and/or absorb the gas, thereby capturing and immobilizing the gas. The bed of reactive material is contained by appropriate support screens within drum 705 so that treated gas can exit via vent holes 707 in the bottom of the drum.

The motive gas inlet of venturi eductor 705 is connected via line 709 to pressure regulator 711 mounted on high pressure gas supply cylinder 713, which provides gas for flow through venturi eductor 703 to generate a low pressure at the aspirated inlet. The high pressure gas may be, for example, nitrogen, other inert gas, or compressed air. Scrubbing drum 705 is sized to process a larger gas leakage rate, for example, greater than 50 sccm, for an operating period of several hours up to 100 hours. This drum typically has a volume of 200 to 250 liters.

Venturi eductor 703 is operated to generate a slightly subatmospheric pressure at the aspirated inlet, thereby drawing gas from containment enclosure 201 through hose 701 and discharging it into scrubbing drum 705. Because containment enclosure 201 is not completely sealed, an amount of atmospheric air enters the enclosure, thereby acting as a purge gas that mixes with the leaking reactive gas. This gas mixture and the motive gas from venturi eductor 703 are treated in scrubbing drum 705, wherein the reactive gas is captured, and clean gas is vented to the atmosphere via openings 707.

The reactive material used in scrubbing drum 705 will depend on the reactive nature of the leaking gas and is selected to properly react with and capture the leaking gas. The reactive material may be a caustic neutralizer such as sodium hydroxide or potassium hydroxide for capturing acid gases such as anhydrous ammonia. Other caustic reactive materials may be used as appropriate. For gases such as boron trichloride, boron trifluoride, carbonyl sulfide, hydrogen bromide, hydrogen chloride, hydrogen iodide, silicon tetrachloride, silicon tetrafluoride, trichlorosilane, and tungsten hexafluoride, an acid neutralizer such as citric acid or ascorbic acid may be used for the reactive material. Alternatively, an oxidizer such as potassium permanganate may be used. Other acidic or oxidizing materials may be used as appropriate. For fluorine or fluorine-containing gases, alumina is an appropriate reactive material. Scrubbing drum 705 may be fabricated from a plastic material such as, for example, polyvinyl chloride (PVC). Alternatively, the scrubbing drum may be fabricated from any appropriate metal such as carbon steel, stainless steel, or other corrosion-resistant alloys.

Because of the larger size of the scrubber vessel and compressed gas cylinder of the embodiment of Fig. 7 compared with the embodiment of Fig. 6, the leak containment system of Fig. 7 typically is transported to a leak site by an emergency response vehicle.

### EXAMPLE

An ISO-type multiple-cylinder module containing a fluorine-nitrogen mixture is offloaded from a ship at a port. An emergency response team is present during the offloading according to standard practice in order to check the module before land transport to the customer. The ER team detects a small leak of about 1x10⁻³ cm³/sec at the bull plug of one of the cylinders. While this leak is minor, the toxicity of fluorine and the low odor threshold of the leaking gas prohibit land transportation of the module to the customer. The leaking cylinder could be handled at the dock by the ER team by emptying the leaking cylinder and reacting the withdrawn gas with scrubbing material to immobilize the gas. However, this approach could take up to 48 hours, would have some associated risk, and would require closure of the dock area during the procedure. This could result in a significant economic penalty because of the dock area closure.

The ER team decides to handle the leak by utilizing the containment cap described above with reference to Figs. 2-5 and the process of Fig. 6. In this case, the cylinder does not have a safety relief device and therefore does not have tee fitting 11, externally-threaded compression fitting body 23, tube 25, and compression fitting 27. Because pigtail 19 need not be removed, enclosure 201 is placed over and around fluid flow fitting 203 such that slot 205 slides over pigtail 19. Containment enclosure 201 is placed over the leaking fluid flow fitting, and magnets 409 and 411 are attached to the ISO module to hold the containment enclosure in place. Slot 205 fits over the pigtail and is partially closed off using duct tape to allow some leakage of ambient air into containment enclosure 201. Line 601 is attached to outlet 207, pressurized nitrogen flow is initiated from cylinder 611 via line 607 through venturi eductor 605, and a mixture of leaking gas and inflowing air is withdrawn from containment enclosure 201 and through scrubbing vessel 603, wherein the reactive gas is captured by alumina. Clean gas is vented to the atmosphere via line 613.

While gas withdrawal and treatment continues, the ISO container is transported by truck and followed by the ER team to a production facility with the proper equipment to handle the leak and repair the leaking cylinder. Because the ISO module is no longer at the dock, the dock area can be reopened for normal operation.

## Claims

1. A fluid storage and leak containment system comprising
(a) a fluid storage vessel system comprising at least one vessel having an interior, an exterior, and an outlet opening between the interior and the exterior;
(b) a fluid flow fitting (203), sealably connected to the outlet opening and adjacent the exterior of the at least one vessel, for withdrawing reactive gas from the interior of the vessel;
(c) a containment enclosure (201) having an interior, an exterior, an open end, and an extraction port (207, 209) for the withdrawal of gas from the interior of the containment enclosure (201), wherein the open end fits over and around the fluid flow fitting (203) such that the containment enclosure (201) surrounds the fluid flow fitting (203) to collect any reactive gas leaking from the fluid flow fitting (203), which containment enclosure (201) is removably attachable to the fluid storage vessel system around the fluid flow fitting (203); and
(d) an attachment member connected to the containment enclosure (201), wherein the attachment member is for removably attaching the containment enclosure (201) to the fluid storage vessel system and pressing the open end of the enclosure (201) against the fluid storage vessel system around the fluid flow fitting (203);
**characterised in that** the attachment member comprises an elastic body (401, 403) having a first end and a second end, wherein the first end is connected to the exterior of the containment enclosure (201) and the second end is removably attachable to the fluid storage vessel system such that the elastic body is in tension, wherein the elastic body (401, 403) has a magnet (409,411) fixed to the second end, and wherein the magnet (409, 411) provides a removable magnetic attachment to the fluid storage vessel system.

2. The system of Claim 1 wherein the elastic body (401, 403) comprises a metal spring or a cord made of elastomeric material.

3. The system of any preceding claim wherein the containment enclosure (201) has a slot (205) for receiving a conduit attached to the fluid flow fitting (203) when placed over and around the fluid flow fitting (203).

4. The system of any preceding claim comprising a gas evacuation device for flow communication with the extraction port (207, 209) of the containment enclosure (201), wherein the gas evacuation device is operable to withdraw gas from the interior of the containment enclosure (201).

5. The system of Claim 4 wherein the gas evacuation device is a vacuum pump or a venturi eductor (605) driven by a pressurized gas.

6. The system of Claim 4 or 5 comprising a scrubbing vessel (603) for flow communication with the gas evacuation device, wherein the scrubbing vessel (603) contains reactive material to capture any reactive gas withdrawn from the containment enclosure (201).

7. The system of Claim 6 wherein:
the scrubbing vessel (603) has an inlet, in flow communication with the extraction port (207, 209), and an outlet; and
the gas evacuation device is a venturi eductor (605) having a pressurized gas inlet, an aspirated inlet, and an outlet, wherein the aspirated inlet is in flow communication with the scrubbing vessel (603).

8. The system of Claim 7 wherein the venturi eductor (605) in operation either:
(i) withdraws the gas from the extraction port (207, 209) and discharges the gas into the scrubbing vessel (603); or
(ii) is installed in an outlet of the scrubbing vessel (603) such that gas is drawn from the extraction port (207, 209) and through the scrubbing vessel (603) and wherein the venturi eductor (605) withdraws gas from the scrubbing vessel (603).

9. The system of any one of Claims 6 to 8 wherein the reactive material is selected from alumina, sodium hydroxide, potassium hydroxide, citric acid, ascorbic acid, and potassium permanganate.

10. The system of any preceding claim wherein the fluid storage vessel system comprises a plurality of fluid storage vessels, each fluid storage vessel having an interior, an exterior, an outlet opening between the interior and the exterior, and a fluid flow fitting (203) sealably connected to the outlet opening and adjacent the exterior of the fluid storage vessel for withdrawing a reactive gas from the interior of the vessel.

11. The system of Claim 10 wherein the the plurality of fluid storage vessels are installed in a tube trailer.

12. A leak containment cap for use in the system of Claim 1, the leak containment cap comprising:
(a) a containment enclosure (201) having an interior, an exterior, an open end, and an extraction port (207, 209) for the withdrawal of gas from the interior of the enclosure, wherein the open end fits over and around a fluid flow fitting (203), that is connectable to an outlet of a fluid storage vessel of a fluid storage vessel system, such that the enclosure (201) can surround the fluid flow fitting (203) and contact the fluid storage vessel system; and
(b) an attachment member connected to the containment enclosure (201), wherein the attachment member is suitable for removably attaching the containment enclosure (201) to the fluid storage vessel system and pressing the open end of the enclosure against the fluid storage vessel system around the fluid flow fitting (203),
**characterised in that** the attachment member comprises an elastic body (401, 403) having a first end and a second end, wherein the first end is connected to the exterior of the containment enclosure (201) and the second end is removably attachable to the fluid storage vessel system such that the elastic body is in tension, wherein the elastic body (401, 403) has a magnet (409, 411) fixed to the second end, and wherein the magnet (409, 411) provides a removable magnetic attachment to the fluid storage vessel system.

13. The leak containment cap of Claim 12 wherein the attachment member and/or containment enclosure (201) are as further defined in Claim 2 or Claim 3.

14. A method for containing a leak of a reactive gas from a fluid storage vessel system, the method comprising:
(a) detecting a leak of the reactive gas from a fluid flow fitting (203) connected to a fluid storage vessel system, wherein:
the fluid storage vessel system comprises at least one fluid storage vessel having an interior, an exterior, and an outlet opening between the interior and the exterior; and
the fluid flow fitting (203) sealably is connected to the outlet opening and adjacent the exterior of the at least one fluid storage vessel, the fluid flow fitting (203) allowing for withdrawal of reactive gas from the interior of the vessel;
(b) placing a containment enclosure (201) over and around the fluid flow fitting (203) so that the enclosure completely surrounds the fluid flow fitting (203), the enclosure (201) having an interior, an exterior, an open end, an extraction port (207, 209) for the withdrawal of gas from the interior of the enclosure, wherein the open end fits over and around the fluid flow fitting (203) such that the enclosure (201) surrounds the fluid flow fitting (203) and contacts the fluid storage vessel system, and an attachment member connected to the containment enclosure (201), which attachment member comprises an elastic body (401, 403) having a first end and a second end, wherein the first end is connected to the exterior of the containment enclosure (201), and a magnet (409, 411) is fixed to the second end;
(c) removably attaching the attachment member to the fluid storage vessel system by means of the magnet (409, 411) attached to the second end of the elastic body (401, 403) such that the elastic body is in tension and presses the open end of the enclosure (201) against the fluid storage vessel system around the fluid flow fitting (203); and
(d) collecting in the enclosure reactive gas leaking from the fluid flow fitting (203).

15. The method of Claim 14 wherein step (d) further comprises withdrawing through the extraction port (207, 209) the reactive gas collected in the enclosure (201), and reacting the reactive gas with reactive material, thereby capturing and immobilizing the reactive gas leaking from the fluid flow fitting (203).

16. The method of Claim 15 wherein an external displacement gas enters the enclosure and mixes with the reactive gas collected from the leak in the fluid flow fitting (203).

17. The method of Claim 16 wherein the external displacement gas is a portion of the ambient air surrounding the fluid storage vessel.

18. The method of any one of Claims 15 to 17 wherein the withdrawal of the gas through the extraction port (207, 209) is effected by a gas evacuation device and the gas is reacted with the reactive material in a scrubbing vessel (603) in flow communication with the gas evacuation device.

19. The method of Claim 18 wherein the gas evacuation device either
(i) withdraws the gas from the extraction port (207, 209) and discharges the gas into the scrubbing vessel (603) or
(ii) is installed in an outlet of the scrubbing vessel (603) such that gas is drawn from the extraction port (207, 209) and through the scrubbing vessel (603), and the gas evacuation device withdraws gas from the scrubbing vessel (603).

20. The method of any one of Claims 14 to 19 wherein the reactive gas is selected from anhydrous ammonia, boron trichloride, boron trifluoride, carbonyl sulfide, hydrogen bromide, hydrogen chloride, hydrogen iodide, silicon tetrachloride, silicon tetrafluoride, trichlorosilane, tungsten hexafluoride, fluorine, and a mixture of fluorine and nitrogen.

21. The method of any one of Claims 14 to 20 wherein the fluid storage vessel is one of a plurality of fluid storage vessels installed in a tube trailer.

22. A method for responding to a leak of a reactive gas from a fluid storage vessel system, the method comprising carrying out steps (a) to (d) according to Claim 15 and then:
(e) while continuing to capture and immobilize the reactive gas from the fluid storage vessel, transporting the fluid storage vessel system to a repair facility; and
(f) removing the reactive gas from the fluid storage vessel.

## Patentansprüche

1. Fluidspeicher- und Lecksicherheitsbehältersystem, das umfasst:
(a) ein Fluidspeichergefäßsystem, das wenigstens ein Gefäß umfasst, das einen Innenraum, einen Außenraum und eine Auslassöffnung zwischen dem Innenraum und dem Außenraum aufweist;
(b) ein Fluidstromanschlussstück (203), das abdichtbar mit der Auslassöffnung verbunden und benachbart zu dem Außenraum des wenigstens einen Gefäßes ist, zum Entnehmen von Reaktionsgas aus dem Innenraum des Gefäßes;
(c) eine Sicherheitsbehälterhülle (201), die einen Innenraum, einen Außenraum, ein offnes Ende und eine Entnahmeöffnung (207, 209) zum Entnehmen von Gas aus dem Inneren der Sicherheitsbehälterhülle (201) aufweist, wobei das offene Ende über und um das Fluidstromanschlussstück (203) passt, so dass die Sicherheitsbehälterhülle (201) das Fluidstromanschlussstück (203) umgibt, um alles Reaktionsgas zu sammeln, das aus dem Fluidstromanschlussstück (203) austritt, wobei die Sicherheitsbehälterhülle (201) abnehmbar an dem Fluidspeichergefäßsystem um das Fluidstromanschlussstück (203) angebracht werden kann; und
(d) ein Befestigungselement, das mit der Sicherheitsbehälterhülle (201) verbunden ist, wobei das Befestigungselement zum abnehmbaren Anbringen der Sicherheitsbehälterhülle (201) an dem Fluidspeichergefäßsystem und Drücken des offenen Endes der Hülle (201) gegen das Fluidspeichergefäßsystem um das Fluidstromanschlussstück (203) dient;
**dadurch gekennzeichnet, dass** das Befestigungselement einen verformbaren Körper (401, 403), der ein erstes Ende und ein zweites Ende aufweist, umfasst, wobei das erste Ende mit dem Außenraum der Sicherheitsbehälterhülle (201) verbunden ist und das zweite Ende abnehmbar an dem Fluidspeichergefäßsystem angebracht werden kann, so dass der verformbare Körper unter Spannung ist, wobei der verformbare Körper (401, 403) einen Magneten (409, 411) aufweist, der an dem zweiten Ende befestigt ist, und wobei der Magnet (409, 411) eine abnehmbare magnetische Befestigung an dem Fluidspeichergefäßsystem zur Verfügung stellt.

2. System nach Anspruch 1, wobei der verformbare Körper (401, 403) eine Metallfeder oder ein Kabel, das aus elastischem Polymer hergestellt ist, umfasst.

3. System nach einem der vorhergehenden Ansprüche, wobei die Sicherheitsbehälterhülle (201) einen Spalt (205) aufweist, um eine an dem Fluidstromanschlussstück (203) angebrachte Leitung aufzunehmen, wenn sie über und um das Fluidstromanschlussstück angeordnet ist.

4. System nach einem der vorhergehenden Ansprüche, das eine Gasevakuierungsvorrichtung zur Strömungskommunikation mit der Entnahmeöffnung (207, 209) der Sicherheitsbehälterhülle (201) umfasst, wobei die Gasevakuierungsvorrichtung betrieben werden kann, um Gas aus dem Innenraum der Sicherheitsbehälterhülle (201) abzuziehen.

5. System nach Anspruch 4, wobei die Gasevakuierungsvorrichtung eine Vakuumpumpe oder ein Venturi-Eduktor (605) ist, der von einem unter Druck stehenden Gas angetrieben wird.

6. System nach Anspruch 4 oder 5, das ein Waschgefäß (603) zur Strömungskommunikation mit der Gasevakuierungsvorrichtung aufweist, wobei das Waschgefäß (603) reaktives Material enthält, um alles Reaktionsgas, das aus der Sicherheitsbehälterhülle (201) abgezogen ist, einzufangen.

7. System nach Anspruch 6, wobei:
das Waschgefäß (603) einen Einlass in Strömungskommunikation mit der Entnahmeöffnung (207, 209) und einen Auslass aufweist; und
die Gasevakuierungsvorrichtung ein Venturi-Eduktor (605) ist, der einen Einlass für unter Druck stehendes Gas, einen Ansaugeinlass und einen Auslass aufweist, wobei der Ansaugeinlass in Strömungskommunikation mit dem Waschgefäß (603) ist.

8. System nach Anspruch 7, wobei der Venturi-Eduktor (605) im Betrieb entweder:
(i) Gas aus der Entnahmeöffnung (207, 209) abzieht und das Gas in das Waschgefäß (603) ausstößt; oder
(ii) in einem Auslass des Waschgefäßes (603) installiert ist, so dass Gas aus der Entnahmeöffnung (207, 209) und durch das Waschgefäß (603) gesaugt wird, und wobei der Venturi-Eduktor (605) Gas aus dem Waschgefäß (603) abzieht.

9. System nach einem der Ansprüche 6 bis 8, wobei das reaktive Material aus Aluminiumoxid, Natriumhydroxid, Kaliumhydroxid, Zitronensäure, Ascorbinsäure und Kaliumpermanganat ausgewählt ist.

10. System nach einem der vorhergehenden Ansprüche, wobei das Fluidspeichergefäßsystem mehrere Fluidspeichergefäße umfasst, wobei jedes Fluidspeichergefäß einen Innenraum, einen Außenraum, eine Auslassöffnung zwischen dem Innenraum und dem Außenraum und ein Fluidstromanschlussstück (203), das abdichtbar mit der Auslassöffnung verbunden und benachbart zu dem Außenraum des Fluidspeichergefäßes ist, zum Entnehmen eines Reaktionsgases aus dem Innenraum des Gefäßes umfasst.

11. System nach Anspruch 10, wobei die mehreren Fluidspeichergefäße in einem Röhrenanhänger installiert sind.

12. Eine Lecksicherheitsbehälterabdeckung zum Gebrauch in dem System nach Anspruch 1, wobei die Lecksicherheitsbehälterabdeckung umfasst:
(a) eine Sicherheitsbehälterhülle (201), die einen Innenraum, einen Außenraum, ein offenes Ende und eine Entnahmeöffnung (207, 209) zum Entnehmen von Gas aus dem Innenraum der Hülle aufweist, wobei das offene Ende über und um das Fluidstromanschlussstück (203) passt, das mit einem Auslass eines Fluidspeichergefäßes eines Fluidspeichergefäßsystems verbunden werden kann, so dass die Hülle (201) das Fluidstromanschlussstück (203) umgeben und das Fluidspeichergefäßsystem kontaktieren kann; und
(b) ein Befestigungselement, das mit der Sicherheitsbehälterhülle (201) verbunden ist, wobei das Befestigungselement zum abnehmbaren Anbringen der Sicherheitsbehälterhülle (201) an dem Fluidspeichergefäßsystem und Drücken des offenen Endes der Hülle gegen das Fluidspeichergefäßsystem um das Fluidstromanschlussstück (203) geeignet ist,
**dadurch gekennzeichnet, dass** das Befestigungselement einen verformbaren Körper (401, 403) umfasst, der ein erstes Ende und ein zweites Ende aufweist, wobei das erste Ende mit dem Außenraum der Sicherheitsbehälterhülle (201) verbunden ist und das zweite Ende abnehmbar an dem Fluidspeichergefäßsystem angebracht werden kann, so dass der verformbare Körper unter Spannung ist, wobei der verformbare Körper (401, 403) einen Magneten (409, 409) aufweist, der an dem zweiten Ende befestigt ist, und wobei der Magnet (411, 411) eine abnehmbare magnetische Befestigung an das Fluidspeichergefäßsystem zur Verfügung stellt.

13. Lecksicherheitsbehälterabdeckung nach Anspruch 12, wobei das Befestigungselement und/oder die Sicherheitsbehälterhülle wie ferner in Anspruch 2 oder Anspruch 3 definiert beschaffen sind.

14. Verfahren zum Eindämmen eines Austretens eines Reaktionsgases aus einem Fluidspeichergefäßsystem, wobei das Verfahren umfasst:
(a) Detektieren eines Austretens eines Reaktionsgases aus einem Fluidstromanschlussstück (203), das mit einem Fluidspeichergefäßsystem verbunden ist, wobei:
das Fluidspeichergefäßsystem wenigstens ein Fluidspeichergefäß umfasst, das einen Innenraum, einen Außenraum und eine Auslassöffnung zwischen dem Innenraum und dem Außenraum aufweist; und
das Fluidstromanschlussstück (203) abdichtbar mit der Auslassöffnung verbunden und zu dem Außenraum des wenigstens einen Fluidspeichergefäßes benachbart ist, wobei das Fluidstromanschlussstück (203) das Entnehmen von Reaktionsgas aus dem Innenraum des Gefäßes ermöglicht;
(b) Anordnen einer Sicherheitsgefäßhülle (201) über und um das Fluidstromanschlussstück (203), so dass die Hülle das Fluidstromanschlussstück (203) vollständig umgibt, wobei die Hülle (201) einen Innenraum, einen Außenraum, ein offenes Ende, eine Entnahmeöffnung (207, 209) zum Entnehmen von Gas aus dem Innenraum der Hülle aufweist, wobei das offene Ende über und um das Fluidstromanschlussstück (203) passt, so dass die Hülle (201) das Fluidstromanschlussstück (203) umgibt und das Fluidspeichergefäßsystem kontaktiert, und eines Befestigungselements, das mit der Sicherheitsbehälterhülle (201) verbunden ist, wobei das Befestigungselement einen verformbaren Körper (401, 403) umfasst, der ein erstes Ende und ein zweites Ende aufweist, wobei das erste Ende mit dem Außenraum der Sicherheitsbehälterhülle (201) verbunden ist und ein Magnet (409, 411) an dem zweiten Ende befestigt ist;
(c) Lösbares Anbringen des Befestigungselements an dem Fluidspeichergefäßsystem mit Hilfe des Magneten (409, 411), der an dem zweiten Ende des verformbaren Körpers (401, 403) angebracht ist, so dass der verformbare Körper in Spannung ist und das offene Ende der Hülle (201) gegen das Fluidspeichergefäßsystem um das Fluidstromanschlussstück (203) drückt; und
(d) Sammeln des Reaktionsgases, das aus dem Fluidstromanschlussstück (203) austritt, in der Hülle.

15. Verfahren nach Anspruch 14, wobei Schritt (d) ferner das Entnehmen des Reaktionsgases, das in der Hülle (201) gesammelt wird, durch die Entnahmeöffnung (207, 209) und das Reagierenlassen des Reaktionsgases mit reaktivem Material und dadurch Einfangen und Blockieren des Reaktionsgases, das aus dem Fluidstromanschlussstück (203) austritt, umfasst.

16. Verfahren nach Anspruch 15, wobei ein externes Verdrängungsgas in die Hülle eintritt und sich mit dem Reaktionsgas, das aus dem Leck in dem Fluidstromanschlussstück (203) gesammelt wird, vermischt.

17. Verfahren nach Anspruch 16, wobei das externe Verdrängungsgas ein Anteil der Umgebungsluft ist, die das Fluidspeichergefäß umgibt.

18. Verfahren nach einem der Ansprüche 15 bis 17, wobei das Entnehmen des Gases durch die Entnahmeöffnung (207, 209) durch eine Gasevakuierungsvorrichtung bewirkt wird und das Gas in einem Waschgefäß (603), das in Strömungskommunikation mit der Gasevakuierungsvorrichtung ist, mit dem reaktiven Material zur Reaktion gebracht wird.

19. Verfahren nach Anspruch 18, wobei die Gasevakuierungsvorrichtung entweder
(i) das Gas aus der Entnahmeöffnung (207, 209) entnimmt und das Gas in das Waschgefäß (603) ausstößt oder
(ii) in einem Auslass des Waschgefäßes (603) installiert ist, so dass Gas aus der Entnahmeöffnung (207, 209) und durch das Waschgefäß (603) gesaugt wird, und wobei die Gasevakuierungsvorrichtung Gas aus dem Waschgefäß (603) abzieht.

20. Verfahren nach einem der Ansprüche 14 bis 19, wobei das Reaktionsgas aus Ammoniakanhydrid, Bortrichlorid, Bortrifluorid, Kohlenoxidsulfid, Bromwasserstoff, Chlorwasserstoff, Iodwasserstoff, Siliciumtetrachlorid, Siliciumtetrafluorid, Trichlorsilan, Wolframhexafluorid, Fluor und einer Mischung aus Fluor und Stickstoff ausgewählt ist.

21. Verfahren nach einem der Ansprüche 14 bis 20, wobei das Fluidspeichergefäß eines von mehreren Fluidspeichergefäßen ist, die in einem Röhrenanhänger installiert sind.

22. Verfahren zum Reagieren auf ein Austreten eines Reaktionsgases aus einem Fluidspeichergefäßsystem, wobei das Verfahren das Ausführen der Schritte (a) bis (d) nach Anspruch 15 umfasst und dann:
(e) Transportieren des Fluidspeichergefäßsystems zu einer Reparatureinrichtung während des Weiterführens des Einfangens und Blockierens des Reaktionsgases aus dem Fluidspeichergefäß; und
(f) Entfernen des Reaktionsgases aus dem Fluidspeichergefäß.

## Revendications

1. Système de confinement de fuites et de stockage de fluide comprenant
(a) un système de cuve de stockage de fluide comprenant au moins une cuve ayant un intérieur, un extérieur et une ouverture de sortie entre l'intérieur et l'extérieur ;
(b) un raccord d'écoulement de fluide (203) relié de manière étanche à l'ouverture de sortie et contiguë à l'extérieur de l'au moins une cuve, pour le retrait de gaz réactif depuis l'intérieur de la cuve ;
(c) une enceinte de confinement (201) ayant un intérieur, un extérieur, une extrémité ouverte et un orifice d'extraction (207, 209) pour le retrait de gaz depuis l'intérieur de l'enceinte de confinement (201), dans lequel l'extrémité ouverte s'adapte sur et autour du raccord d'écoulement de fluide (203) de sorte que l'enceinte de confinement (201) entoure le raccord d'écoulement de fluide (203) pour collecter toute fuite de gaz réactif depuis le raccord d'écoulement de fluide (203), laquelle enceinte de confinement (201) peut être fixée de manière détachable au système de cuve de stockage de fluide autour du raccord d'écoulement de fluide (203) ; et
(d) un élément d'attachement relié à l'enceinte de confinement (201), dans lequel l'élément d'attachement est destiné à attacher de manière amovible l'enceinte de confinement (201) au système de cuve de stockage de fluide et à presser l'extrémité ouverte de l'enceinte (201) contre le système de cuve de stockage de fluide autour du raccord d'écoulement de fluide (203) ;
**caractérisé en ce que** l'élément d'attachement comprend un corps élastique (401, 403) ayant une première extrémité et une seconde extrémité, dans lequel la première extrémité est reliée à l'extérieur de l'enceinte de confinement (201) et la seconde extrémité peut être attachée de manière amovible au système de cuve de stockage de fluide de sorte que le corps élastique soit sous tension, dans lequel le corps élastique (401, 403) présente un aimant (409, 411) fixé à la seconde extrémité, et dans lequel l'aimant (409, 411) fournit un attachement magnétique amovible au système de cuve de stockage de fluide.

2. Système selon la revendication 1, dans lequel le corps élastique (401, 403) comprend un ressort métallique ou un cordon en matériau élastomère.

3. Système selon l'une quelconque des revendications précédentes, dans lequel l'enceinte de confinement (201) présente une fente (205) destinée à recevoir un conduit attaché au raccord d'écoulement de fluide (203) lorsqu'elle est placée sur et autour du raccord d'écoulement de fluide (203).

4. Système selon l'une quelconque des revendications précédentes comprenant un dispositif d'évacuation de gaz pour la communication d'écoulement avec l'orifice d'extraction (207, 209) de l'enceinte de confinement (201), dans lequel le dispositif d'évacuation de gaz est utilisable pour le retrait de gaz depuis l'intérieur de l'enceinte de confinement (201).

5. Système selon la revendication 4, dans lequel le dispositif d'évacuation de gaz est une pompe à vide ou un éjecteur venturi (605) entraîné par un gaz pressurisé.

6. Système selon la revendication 4 ou 5, comprenant une cuve de lavage (603) pour la communication d'écoulement avec le dispositif d'évacuation de gaz, dans lequel la cuve de lavage (603) contient un matériau réactif pour capturer tout gaz réactif retiré de l'enceinte de confinement (201).

7. Système selon la revendication 6, dans lequel :
la cuve de lavage (603) présente une entrée en communication d'écoulement avec l'orifice d'extraction (207, 209) et une sortie ; et
le dispositif d'évacuation de gaz est un éjecteur venturi (605) présentant une entrée de gaz pressurisé, une entrée d'aspiration et une sortie, dans lequel l'entrée d'aspiration est en communication d'écoulement avec la cuve de lavage (603).

8. Système selon la revendication 7, dans lequel l'éjecteur venturi (605) en fonctionnement :
(i) retire le gaz depuis l'orifice d'extraction (207, 209) et l'évacue dans la cuve de lavage (603) ; ou
(ii) est installé dans une sortie de la cuve de lavage (603) de sorte que le gaz soit tiré depuis l'orifice d'extraction (207, 209) et à travers la cuve de lavage (603), et dans lequel l'éjecteur venturi (605) retire le gaz de la cuve de lavage (603).

9. Système selon l'une quelconque des revendications 6 à 8, dans lequel le matériau réactif est sélectionné parmi l'alumine, l'hydroxyde de sodium, l'hydroxyde de potassium, l'acide citrique, l'acide ascorbique et le permanganate de potassium.

10. Système selon l'une quelconque des revendications précédentes, dans lequel le système de cuve de stockage de fluide comprend une pluralité de cuves de stockage de fluide, chaque cuve de stockage de fluide ayant un intérieur, un extérieur, une ouverture de sortie entre l'intérieur et l'extérieur, et un raccord d'écoulement de fluide (203) relié de manière étanche à l'ouverture de sortie et contiguë à l'extérieur de la cuve de stockage de fluide pour retirer un gaz réactif de l'intérieur de la cuve.

11. Système selon la revendication 10, dans lequel la pluralité de cuves de stockage de fluide est installée dans une remorque porte-tubes.

12. Dôme de confinement de fuites pour une utilisation dans le système selon la revendication 1, le dôme de confinement de fuite comprenant :
(a) une enceinte de confinement (201) ayant un intérieur, un extérieur, une extrémité ouverte et un orifice d'extraction (207, 209) pour le retrait de gaz depuis l'intérieur de l'enceinte, dans lequel l'extrémité ouverte s'adapte sur et autour d'un raccord d'écoulement de fluide (203) qui peut être relié à une sortie d'une cuve de stockage de fluide d'un système de cuve de stockage de fluide de sorte que l'enceinte (201) puisse entourer le raccord d'écoulement de fluide (203) et toucher le système de cuve de stockage de fluide ; et
(b) un élément d'attachement relié à l'enceinte de confinement (201), dans lequel l'élément d'attachement est adapté pour fixer de manière détachable l'enceinte de confinement (201) au système de cuve de stockage de fluide et presser l'extrémité ouverte de l'enceinte contre le système de cuve de stockage de fluide autour du raccord d'écoulement de fluide (203),
**caractérisé en ce que** l'élément d'attachement comprend un corps élastique (401, 403) ayant une première extrémité et une seconde extrémité, dans lequel la première extrémité est reliée à l'extérieur de l'enceinte de confinement (201) et la seconde extrémité peut être fixée de manière détachable au système de cuve de stockage de fluide de sorte que le corps élastique soit sous tension, dans lequel le corps élastique (401, 403) présente un aimant (409, 411) fixé à la seconde extrémité, et dans lequel l'aimant (409, 411) fournit un attachement magnétique amovible au système de cuve de stockage de fluide.

13. Dôme de confinement de fuite selon la revendication 12, dans lequel l'élément d'attachement et/ou l'enceinte de confinement (201) sont en outre réalisés selon la revendication 2 ou 3.

14. Procédé de confinement d'une fuite d'un gaz réactif depuis système de cuve de stockage de fluide, le procédé comprenant les étapes suivantes :
(a) détecter une fuite du gaz réactif depuis raccord d'écoulement de fluide (203) relié à un système de cuve de stockage de fluide, dans lequel :
le système de cuve de stockage de fluide comprend au moins une cuve de stockage de fluide ayant un intérieur, un extérieur, et une ouverture de sortie entre l'intérieur et l'extérieur ; et
le raccord d'écoulement de fluide (203) est relié de manière étanche à l'ouverture de sortie et contiguë à l'extérieur de l'au moins une cuve de stockage de fluide, le raccord d'écoulement de fluide (203) permettant le retrait du gaz réactif depuis l'intérieur de la cuve ;
(b) placer une enceinte de confinement (201) sur et autour du raccord d'écoulement de fluide (203) de sorte que l'enceinte entoure complètement le raccord d'écoulement de fluide (203), l'enceinte (201) ayant un intérieur, un extérieur, une extrémité ouverte, un orifice d'extraction (207, 209) pour le retrait du gaz depuis l'intérieur de l'enceinte, dans lequel l'extrémité ouverte s'adapte sur et autour du raccord d'écoulement de fluide (203) de sorte que l'enceinte (201) entoure le raccord d'écoulement de fluide (203) et touche le système de cuve de stockage de fluide, et un élément d'attachement relié à l'enceinte de confinement (201), lequel élément d'attachement comprend un corps élastique (401, 403) ayant une première extrémité et une seconde extrémité, dans lequel la première extrémité est reliée à l'extérieur de l'enceinte de confinement (201), et un aimant (409, 411) est fixé à la seconde extrémité ;
(c) fixer de manière détachable l'élément d'attachement au système de cuve de stockage de fluide à l'aide de l'aimant (409, 411) attaché à la seconde extrémité du corps élastique (401, 403) de sorte que le corps élastique soit sous tension et presse l'extrémité ouverte de l'enceinte (201) contre le système de cuve de stockage de fluide autour du raccord d'écoulement de fluide (203) ; et
(d) collecter dans l'enceinte le gaz réactif qui fuit du raccord d'écoulement de fluide (203).

15. Procédé selon la revendication 14, dans lequel l'étape d) comprend en outre le retrait par l'orifice d'extraction (207, 209) du gaz réactif collecté dans l'enceinte (201), et la réaction du gaz réactif avec du matériau réactif, capturant et immobilisant par là-même le gaz réactif qui fuit du raccord d'écoulement de fluide (203).

16. Procédé selon la revendication 15, dans lequel un gaz de déplacement externe entre dans l'enceinte et se mélange avec le gaz réactif collecté de la fuite dans le raccord d'écoulement de fluide (203).

17. Procédé selon la revendication 16, dans lequel le gaz de déplacement externe est une partie de l'air ambiant entourant la cuve de stockage de fluide.

18. Procédé selon l'une quelconque des revendications 15 à 17, dans lequel le retrait du gaz par l'orifice d'extraction (207, 209) est réalisé par un dispositif d'évacuation de gaz et le gaz réagit avec le matériau réactif dans une cuve de lavage (603) en communication d'écoulement avec le dispositif d'évacuation de gaz.

19. Procédé selon la revendication 18, dans lequel le dispositif d'évacuation de gaz
(i) retire le gaz de l'orifice d'extraction (207, 209) et évacue le gaz dans la cuve de lavage (603) ou
(ii) est installé dans une sortie de la cuve de lavage (603) de sorte que le gaz soit tiré depuis l'orifice d'extraction (207, 209) et à travers la cuve de lavage (603), et le dispositif d'évacuation de gaz retire le gaz de la cuve de lavage (603).

20. Procédé selon l'une quelconque des revendications 14 à 19, dans lequel le gaz réactif est sélectionné parmi l'ammoniac anhydre, le trichlorure de bore, le trifluorure de bore, le sulfure de carbonyle, le bromure d'hydrogène, le chlorure d'hydrogène, l'iodure d'hydrogène, le tétrachlorure de silicium, le tétrafluorure de silicium, le trichlorosilane, l'hexafluorure de tungstène, le fluor et un mélange de fluor et d'azote.

21. Procédé selon l'une quelconque des revendications 14 à 20, dans lequel la cuve de stockage de fluide est une cuve d'une pluralité de cuves de stockage de fluide installées dans une remorque porte-tubes.

22. Procédé de réponse à une fuite d'un gaz réactif provenant d'un système de cuve de stockage de fluide, le procédé comprenant la réalisation des étapes (a) à (d) selon la revendication 15 puis :
(e) tout en continuant la capture et l'immobilisation du gaz réactif provenant de la cuve de stockage de fluide, le transport du système de cuve de stockage de fluide vers une installation de réparation ; et
(f) le retrait du gaz réactif depuis la cuve de stockage de fluide.
